(19) Europäisches Patentamt
European Patent Office
Office européen des brevets

(11) **EP 2 121 203 B1**

(12) **EUROPÄISCHE PATENTSCHRIFT**

(45) Veröffentlichungstag und Bekanntmachung des Hinweises auf die Patenterteilung:
**01.12.2010 Patentblatt 2010/48**

(21) Anmeldenummer: **08714269.1**

(22) Anmeldetag: **22.02.2008**

(51) Int Cl.:
*B07C 5/344* (2006.01)      *G01N 27/02* (2006.01)
*G01N 27/72* (2006.01)      *G01R 27/26* (2006.01)
*G01V 3/10* (2006.01)      *G01R 33/12* (2006.01)

(86) Internationale Anmeldenummer:
**PCT/AT2008/000059**

(87) Internationale Veröffentlichungsnummer:
**WO 2008/101270 (28.08.2008 Gazette 2008/35)**

(54) **VERFAHREN UND VORRICHTUNG ZUM UNTERSCHEIDEN VON EIN ELEKTROMAGNETISCHES WECHSELFELD BEEINFLUSSENDEN OBJEKTEN, INSBESONDERE METALLOBJEKTEN**

METHOD AND DEVICE FOR DIFFERENTIATING OBJECTS INFLUENCING AN ELECTROMAGNETIC ALTERNATING FIELD, PARTICULARLY METAL OBJECTS

PROCÉDÉ ET DISPOSITIF POUR DIFFÉRENCIER DES OBJETS INFLUANT UN CHAMP ALTERNATIF ÉLECTROMAGNÉTIQUE, NOTAMMENT DES OBJETS MÉTALLIQUES

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **23.02.2007 AT 2942007**

(43) Veröffentlichungstag der Anmeldung:
**25.11.2009 Patentblatt 2009/48**

(73) Patentinhaber: **EVK DI Kerschhaggl Gmbh 8074 Raaba (AT)**

(72) Erfinder:
• **KISS, Michael**
  **A-8052 Graz (AT)**
• **KOHLA, Bernhard**
  **A-8042 Graz (AT)**
• **GRAZE, Bernd**
  **A-8010 Graz (AT)**

(74) Vertreter: **Margotti, Herwig Franz Schwarz & Partner Patentanwälte Wipplingerstrasse 30 1010 Wien (AT)**

(56) Entgegenhaltungen:
**WO-A-2005/043195      KR-A- 20060 134 764 US-A- 5 541 510**

• **MESINA M B ET AL: "IMPROVEMENTS IN SEPARATION OF NON-FERROUS SCRAP METALS USING AN ELECTROMAGNETIC SENSOR" PHYSICAL SEPARATION IN SCIENCE AND ENGINEERING, TAYLOR & FRANCIS, ABINGDON, GB, Bd. 12, Nr. 2, 1. Juni 2003 (2003-06-01), Seiten 87-101, XP008046807 ISSN: 1478-6478**
• **DATABASE INSPEC [Online] THE INSTITUTION OF ELECTRICAL ENGINEERS, STEVENAGE, GB; September 2007 (2007-09), CAO QINGSONG ET AL: "Theoretical and experimental study on metal type identification based on eddy current" XP002484496 Database accession no. 9799578 & Chinese Journal of Scientific Instrument China Publications Center China, Bd. 28, Nr. 9, September 2007 (2007-09), Seiten 1718-1722, ISSN: 0254-3087**

**Beschreibung**

Die Erfindung betrifft ein Verfahren und eine Vorrichtung zum Unterscheiden von ein elektromagnetisches Wechselfeld beeinflussenden Objekten, insbesondere Metallobjekten, mittels einer Spule, die an einer Förderstrecke angeordnet ist, auf der ein Materialstrom mit einer vorgegebenen Geschwindigkeit in eine Richtung bewegt wird, wobei der Materialstrom leitfähige und/oder ferromagnetische Objekte aufweisen kann, gemäß den Oberbegriffen der Ansprüche 1 und 12. Weiters umfasst die Erfindung eine Sortieranlage zum Aussortieren von Objekten aus einem Materialstrom.

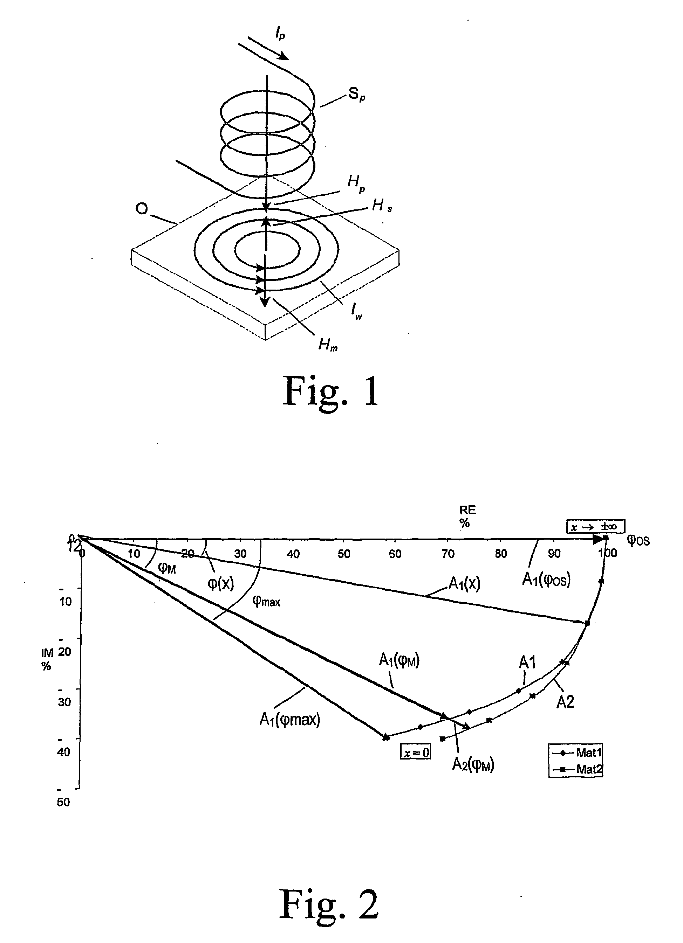

Wird eine Spule S von einem sich zeitlich ändernden Strom $I_p$ durchflossen, baut sich um diese ein elektromagnetisches Feld $H_p$ auf (siehe Fig. 1). Befindet sich ein elektrisch leitendes Objekt O in der Nähe der Spule, werden basierend auf dem elektromagnetischen Induktionsprinzip an dessen Oberfläche und in oberflächennahen Schichten Wirbelströme $I_w$ induziert. Die Stromdichte nimmt dabei mit zunehmender Tiefe ab. Die Wirbelströme $I_w$ haben ihrerseits ein elektromagnetisches Sekundärfeld $H_s$ zur Folge, das dem Primärfeld $H_p$ entgegengerichtet ist und dieses daher schwächt. Dieser Effekt wird auch als *Wirbelstromeffekt* bezeichnet und ist in Fig. 1 dargestellt. Die Induktivität $L_s$ der mit sinusförmigem Strom $I_p$ gespeisten Spule S verringert sich bei Annäherung des leitfähigen Objekts O an die Spule S infolge des Wirbelstromeffekts. Gleichzeitig erhöht sich der ohmsche Anteil $R_s$ der Spule S. Dabei sind $L_S$ und $R_S$ die in Reihe geschalteten Bestandteile eines elektrischen Ersatzschaltbildes zur Beschreibung der Spulenimpedanz $Z_S$ der Spule S. Es gilt: $Z_S = R_S + j\omega \cdot L_S$.

Besteht das elektrisch leitfähige Objekt O jedoch aus ferromagnetischen Materialien, so tritt neben dem Wirbelstromeffekt auch eine Magnetisierung des Objekts O auf. Dadurch entsteht ein weiteres, nicht zu vernachlässigendes Magnetfeld $H_m$ (siehe Fig. 1), das dem Primärfeld $H_p$ gleichgerichtet ist und dieses somit verstärkt. Dieser Effekt wird *ferromagnetischer Effekt* genannt und überlagert sich dem Wirbelstromeffekt. Der ferromagnetische Effekt ist in der Regel stärker ausgeprägt als der Wirbelstromeffekt, es kommt dadurch tendenziell zu einer Erhöhung der Induktivität $L_s$ sowie auch zu einer Erhöhung des ohmschen Widerstandes $R_s$ in dem oben beschriebenen Ersatzschaltbild der Spule S.

In der Dissertation von Mallwitz R., "Analyse von Wirbelstromsignalen mit problemangepassten Funktionen für die zerstörungsfreie Materialprüfung", Universität Kassel, 2000, ist der Stand der Technik zur Ermittlung von Materialeigenschaften mithilfe des Wirbelstrom- und ferromagnetischen Effekts dargelegt. Demnach hängen Wirbelströme einerseits von Objekteigenschaften wie der spezifischen Leitfähigkeit σ und der relativen magnetischen Permeabilität $\mu_r$ und damit von physikalischen Materialeigenschaften, aber auch von Oberflächenbeschaffenheit und Homogenität im Wirbelstrombereich, sowie Größe und Form des Objekts, andererseits aber auch von der Erregung (magnetische Primärfeldstärke $H_p$ und Frequenz) und dem Objektabstand ab.

Üblicherweise werden Wirbelströme in leitfähigen Materialien durch Erregerspulen induziert, wobei das Primärfeld durch das resultierende Magnetfeld beeinflusst wird. Diese Beeinflussung führt einerseits zu einer Änderung der Impedanz der Erregerspule, die gemessen werden kann (parametrisches Prinzip), andererseits ändert sich auch die induzierte Spannung in einer zusätzlichen Sekundärspule (transformatorisches Prinzip). Am gebräuchlichsten ist die Anregung der Erregerspule mit sinusförmigem Strom (Einfrequenzverfahren). Gewöhnlich ist die Spule dabei Bestandteil eines Resonanzkreises, meist eines Serienresonanzkreises. Strom und Spannungen innerhalb des Kreises ändern sich, wenn ein leitfähiges Objekt in den Wirkbereich des Spulenfeldes kommt.

Die Messgrößen können unabhängig vom Prinzip entweder absolut (Absolutanordnung) oder als Differenzsignale zu einem Vergleichssensor (Differenzanordnung) gemessen werden.

Die Anregung der Magnetisierungsspule kann auch mit impulsförmigen Strömen erfolgen (Puls-Induktions-Verfahren).

Aus der Europäischen Patentanmeldung EP 1 347 311 A2 ist ein Verfahren zum Aussortieren von Metallobjekten einer bestimmten Materialeigenschaft, insbesondere von Buntmetallen untereinander, mittels mehrerer Puls-Induktions-Einzelsonden, die den Detektor bilden und Induktions-Signale der Metallobjekte erfassen, wobei Änderungen der von den Metallobjekten ausgestrahlten Induktions-Signale zum Aussortieren ausgewertet werden, bekannt.

Aus der DE 198 38 249 A1 ist eine Sortieranlage zum Sortieren von metallischen Partikeln bekannt, mit der es möglich sein soll, herauszufinden, welche Materialien Metallpartikel besitzen. Diese Anlage besteht aus einem Detektor mit Einzelsonden in Array-Anordnung mit hoher räumlicher Auflösung. Die Partikel durchlaufen ein magnetisches Wechselfeld im Frequenzbereich von 0,1 MHz bis 1,0 MHz. In den metallischen Partikeln entstehen Wirbelströme, die das Magnetfeld abschwächen. Diese Änderungen des Magnetfeldes werden von magneto-resistiven Sensoren erfasst und in elektronische Signale umgewandelt, die ausgewertet werden. Die Empfindlichkeit dieses Detektors und der hierfür erzeugte Signalverlauf reichen aber in der Praxis nicht aus, um beispielsweise Buntmetalle zuverlässig untereinander auszusortieren. Zudem ist dieser Detektor relativ aufwendig.

Eine Vorrichtung und ein Verfahren, mit der es möglich ist, Metalle unterschiedlicher Farbe, also Buntmetalle, untereinander auszusortieren, ist in der DE 100 03 562 A1 aufgezeigt und beschrieben. Eine Unterscheidung der Buntmetalle wird erst durch einen optischen Sensor möglich, der als Kamera ausgebildet ist, wobei Metallfragmente ausgeleuchtet werden müssen. Zum Aussortieren sind verschiedene Luftdüsen vorhanden, die einen Schüttgutstrom im freien Fall sortieren können. Zwar ist auch ein zweiter Detektor angeordnet, der als Metalldetektor ausgebildet ist, dieser kann verschiedene Buntmetalle untereinander aber nicht unterscheiden. Der Metalldetektor kann nur Eisenmetalle und Nicht-Eisenmetalle unterscheiden. Er ist daher in der Praxis nur in Kombination mit dem optischen Sensor einsetzbar. Der optische Sensor unterscheidet Metalle nur nach dem Aussehen, nicht jedoch nach ihren elektromagnetischen Eigenschaften.

Es sind auch Verfahren bekannt, bei denen eine Verdampfung von zu trennenden Materialien mit einem Laser erfolgt oder eine radioaktive Bestrahlung dieser Materialien vorgenommen wird. Diese Verfahren sind jedoch relativ aufwendig.

Ferner ist es bekannt und üblich, so genannte Magnetscheider zum Vorsortieren ferromagnetischer Materialien von anderen Verbundstoffen einzusetzen, wobei eine anschließende Trennung aller übrigen Metalle mittels Wirbelstromscheider erfolgt.

Die Signalauswertung bei Einfrequenzverfahren erfolgt üblicherweise durch Auswertung des Scheitelwertes ("Amplitude") und/oder der Phasenverschiebung ("Phase") des sinusförmigen Spulenstromes zur ebenfalls sinusförmigen Anregspannung der Spule. Zur "Amplitudenmessung" werden meist Gleichrichterschaltungen mit nachfolgender Spitzenwertspeicherung, Abtast-Halt-Glieder oder Synchrongleichrichter verwendet. Zur Messung der Phasenverschiebung werden regelmäßig phasenempfindliche Gleichrichter (Synchrongleichrichter) verwendet (siehe das österreichische Patent AT 501669 oder Tietze, U., Schenk, Ch.: "Halbleiter-Schaltungstechnik", 11. neu bearbeitete Auflage (1899), S. 1058, 1212-1218).

Die zuverlässige Informationsgewinnung aus gemessenen Wirbelstromdaten stellt in der Praxis jedoch nach wie vor ein Problem der materialselektiven Wirbelstrommesstechnik dar. Die Ursachen dafür sind in der Komplexität der zugrunde liegenden physikalischen Phänomene zu finden. Daher ist, abgesehen von wenigen Spezialfällen, der Signalentstehungsprozess in allgemeingültiger Form zurzeit nicht beschreibbar und die mathematische Inversion dieser Abbildung nicht möglich (siehe Mallwitz, R. aaO).

Der vorliegenden Erfindung liegt daher die Aufgabe zugrunde, ein Verfahren und eine Vorrichtung zum Unterscheiden von ein elektromagnetisches Wechselfeld beeinflussenden Objekten, insbesondere Metallobjekten bereitzustellen, die eine schnelle, genaue und mit geringem Hardwareaufwand verbundene Unterscheidung der genannten Objekte in einem Materialstrom ermöglichen. Weiters sollen Einflüsse von Größe, Dicke und Form der zu unterscheidenden Objekte auf den Unterscheidungsprozess minimiert werden. Die Vorrichtung soll einfach, robust und störsicher sein und äußerst effizient die Gewinnung von Amplituden- und Phasensignalen bei gleichzeitiger Analog-Digitalwandlung ermöglichen, sodass sich Vorteile bezüglich Schnelligkeit, Kosten und Einfachheit im Aufbau gegenüber den sonst üblichen Anordnungen mit Synchrongleichrichter, Phasendiskriminator und Tiefpass ergeben, wie z.B. in AT 501669 beschrieben.

Die vorliegende Erfindung löst die gestellte Aufgabe durch ein Verfahren zum Unterscheiden von ein elektromagnetisches Wechselfeld beeinflussenden Objekten mit den Merkmalen des Anspruchs 1 sowie durch eine Vorrichtung zum Unterscheiden von ein elektromagnetisches Wechselfeld beeinflussenden Objekten mit den Merkmalen des Anspruchs 12. Vorteilhafte Ausgestaltungen der Erfindung ergeben sich aus den Unteransprüchen. Weiters umfasst die Erfindung eine Sortieranlage mit zumindest einer erfindungsgemäßen Vorrichtung zum Unterscheiden von ein elektromagnetisches Wechselfeld beeinflussenden Objekten.

Wenn das Komparatorfenster, d.h. die Werte des Eintrittspunkts und des Austrittspunkts des Fensters des Fensterkomparators symmetrisch zu einer Signalmittellinie, insbesondere Nulllinie, des Spulenstroms festgelegt werden, erhält man in diesem Bereich für die Berechnung der Steigung lineare Verhältnisse, die die Berechnung einfach machen.

Um morphologische Artefakte möglichst auszuschalten wird vorzugsweise zur Materialbestimmung des Objekts zumindest ein bei einer diskreten Messphase ermittelter Scheitelwert mit entsprechenden Scheitelwerten von Referenzproben verglichen.

Um eine hohe Empfindlichkeit der Messungen zu erreichen, ist es vorteilhaft, wenn zumindest eine Messphase nahe einem bei größter Annäherung des Objekts an die Spule auftretenden maximalen Phasenverschiebungswinkel gewählt wird, wobei jedoch vorzugsweise der Abstand zwischen dem Messphasenwinkel und dem maximalen Phasenverschiebungswinkel zumindest so groß gewählt wird, dass er auch mit den kleinsten im Materialstrom auftretenden Objekten erreicht wird.

Ein weiterer Vorteil der Erfindung ist, dass der Zeitpunkt des Erreichens des Messphasenwinkels bei bekannter Geschwindigkeit des Materialstroms als Referenzzeitpunkt für die Ausbringung des Objekts aus dem Materialstrom verwendet werden kann.

Um ein Maß für die Größe des Objekts zu erhalten, ist vorgesehen, den maximalen Phasenverschiebungswinkel zu bestimmen. Dabei kann der Zeitpunkt des Erreichens des maximalen Phasenverschiebungswinkel bei bekannter Geschwindigkeit des Materialstroms als Referenzzeitpunkt für die Ausbringung des Objekts aus dem Materialstrom verwendet werden.

Für eine noch genauere Auswertung des Materials von Objekten wird durch periodisches Erfassen von Wertepaaren aus Scheitelwert und Phasenverschiebung der Stromverläufe für verschiedene Phasenwinkel die zugehörige Ortskurve punktweise aufgenommen und zur Auswertung durch Vergleich mit Referenzortskurven herangezogen.

Weiters kann eine Normierung vorgesehen werden, indem zunächst aus dem Anregspannungsverlauf und dem Stromverlauf der Spule im von Objekten unbeeinflussten Zustand die Offsetphase ermittelt wird und in weiterer Folge die Messphasenwinkel der Stromverläufe auf die Offsetphase bezogen werden.

Es hat sich herausgestellt, dass die Erfindung bei einer Anreg- bzw. Messfrequenz $f_M$ zwischen 1 kHz und 1 MHz, vorzugsweise zwischen 5 und 100 kHz und am meisten bevorzugt zwischen 10 und 50 kHz hervorragend arbeitet.

Um Einflüsse von Größe und Form des Objekts zu minimieren sollte der Spulendurchmesser kleiner als ein mittlerer Durchmesser der zu unterscheidenden Objekte gewählt werden.

Weitere Vorteile der Erfindung ergeben sich aus der anschließenden ausführlichen Beschreibung beispielhafter Ausführungsformen der Erfindung, auf die dieselbe jedoch nicht beschränkt ist.

Die Erfindung wird nun anhand eines den Schutzbereich der Erfindung nicht limitierenden Ausführungsbeispiels unter Bezugnahme auf die Zeichnungen näher erläutert. In den Zeichnungen zeigen

Fig. 1 das Prinzip der Wirkungen von Wirbelstromeffekt und ferromagnetischem Effekt in einem von einer Spule erzeugten elektromagnetischen Wechselfeld;

Fig. 2 Ortskurven und ausgewählte Zeigerdiagramme, aus denen die durch ein elektrisch leitendes und/oder ferromagnetisches Objekt an einer Spule verursachten Impedanzänderungen hervorgehen;

Fig. 3 Spannungs- und Stromdiagramme zur Erläuterung des erfindungsgemäßen Signalauswerteverfahrens;

Fig. 4 ein schematisches Blockschaltbild einer Ausführungsform einer erfindungsgemäßen Vorrichtung zum Unterscheiden von ein elektromagnetisches Wechselfeld beeinflussenden Objekten;

Fig. 5 ein Signaldiagramm der Ausgangssignale der in der Vorrichtung von Fig. 4 verwendeten Komparatoren; und

Fig. 6 eine schematische Darstellung einer erfindungsgemäßen Sortieranlage.

Die vorliegende Erfindung basiert auf einem nach dem eingangs erwähnten parametrischen Prinzip arbeitenden Einspulenverfahren. Dabei macht man sich die Tatsache zunutze, dass, wenn eine Spule S von einer sinusförmigen Anregspannung konstanter Frequenz angeregt bzw. von einem sinusförmigen Strom $I_p$ durchflossen wird, das um die Spule aufgebaute elektromagnetische Feld $H_p$ durch den Wirbelstromeffekt bzw. den ferromagnetischen Effekt in Wechselwirkung mit einem elektrisch leitenden und/oder ferromagnetischen Objekt O in der Nähe der Spule S tritt. Diese Wechselwirkung führt zu einer Veränderung der Induktivität $L_s$ und des ohmschen Anteils $R_s$ der Spule S, d.h. insgesamt zu einer Veränderung der Spulenimpedanz $Z_S = R_S + j\omega \cdot L_S$ der Spule S.

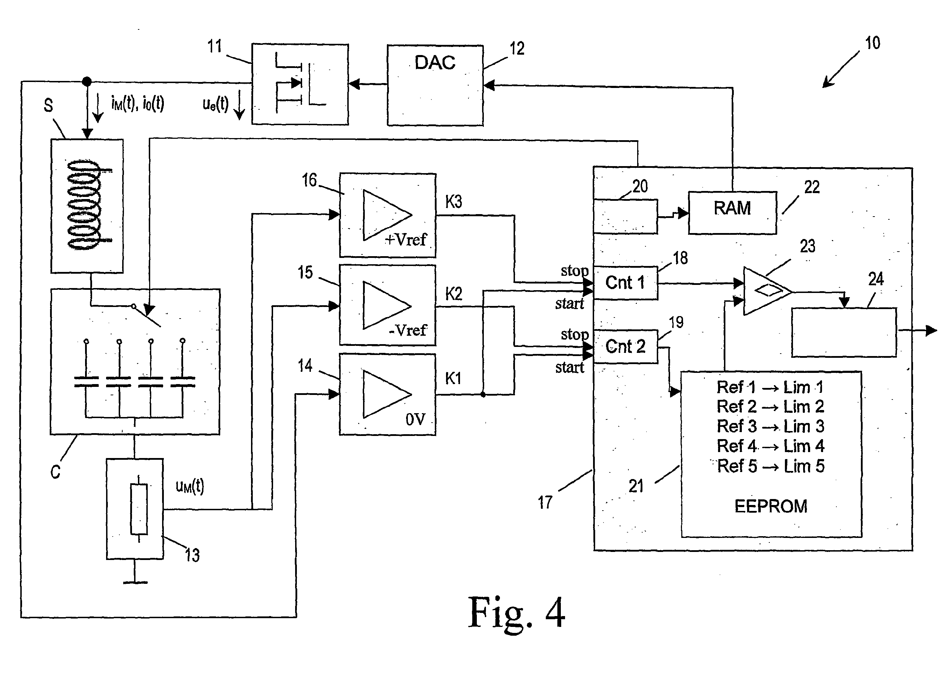

Wie aus dem Blockschaltbild von Fig. 4 zu sehen, das eine Ausführungsform der erfindungsgemäßen Vorrichtung zum Unterscheiden von ein elektromagnetisches Wechselfeld beeinflussenden Objekten zeigt, die weiter unten ausführlich beschrieben wird, ist die Erregerspule S mit einem Kondensator C zu einem Resonanzkreis geschaltet, und zwar in diesem Beispiel durch Serienschaltung von Erregerspule S und Kondensator C zu einem Serienresonanzkreis. Dieser Resonanzkreis wird mit einer sinusförmigen Wechselspannung $u_e(t)$ konstanter Amplitude und Frequenz, vorzugsweise seiner Eigenfrequenz, gespeist, so dass durch die Spule S und damit durch den Serienresonanzkreis ein Strom $i_0(t)$ fließt, der gegenüber der Anregspannung um einen Offset-Phasenwinkel $\varphi_{os}$ phasenversetzt ist.

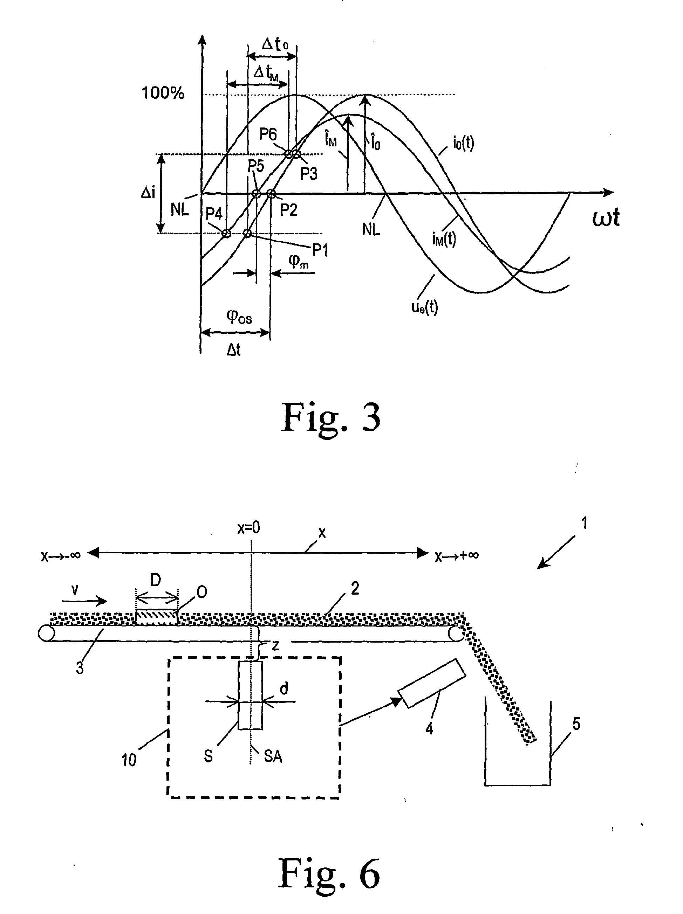

Gelangt nun ein elektrisch leitendes und/oder ferromagnetisches Objekt in den Wirkungsbereich des durch die Spule S erzeugten elektromagnetischen Feldes, so ergibt sich aufgrund der objektmaterialabhängigen Spulenimpedanzänderung eine Amplitudenänderung des Stromes bei gleichzeitiger Phasenverschiebung, die mithilfe der komplexen Wechselstromrechnung ausgewertet werden können. Bewegt sich nun das Objekt O derart an der Spule S vorbei, dass der Objektmittelpunkt (Schwerpunkt) geradlinig (Richtung x, siehe Fig. 6) in einem - in Richtung der Spulenachse SA gemessen -vorgegebenen Abstand z von der Spule S über den Spulenmittelpunkt (Spulenachse SA) geführt wird (d.h. oberhalb oder unterhalb an der Spule S vorbei), ergibt sich ein materialcharakteristischer Verlauf der Betrags- und Phasenänderungen des Spulenstromes in Abhängigkeit von der x-Position des Objekts O zur Spule S.

Trägt man nun für das Objekt O entlang seiner Reise in x-Richtung alle Wertepaare von Betrag (Amplitude bzw. Scheitelwert) A1(x) und Phase $\varphi(x)$ für den Weg von $x \to -\infty$ über $x = 0$ bis $x \to +\infty$ als Zeigerdiagramme in die komplexe Zahlenebene ein, so erhält man eine Ortskurve A1 mit der Objektposition x als Argument. Fig. 2 stellt in der komplexen Zahlenebene die genannte Ortskurve A1 sowie eine zweite Ortskurve A2 für ein zweites Objekt dar, wobei das zweite Objekt aus einem Material Mat2 besteht, das sich in Bezug auf seine elektrische Leitfähigkeit bzw. seine ferromagnetischen Eigenschaften von einem Material Mat1 unterscheidet, aus dem das erste Objekt O besteht, für das die erste Ortskurve A1 aufgenommen wurde.

Zur besseren Übersichtlichkeit wurde im Diagramm von Fig. 2 die Offset-Phase $\varphi_{os}$ der unbedeckten Spule S, d.h. wenn sich kein Objekt O im Wirkungsbereich der Spule S befindet, oder in anderen Worten, wenn $x \to \pm\infty$ geht, mit $\varphi_{os} = 0$ festgelegt und der dabei ermittelte Betrag $A(\varphi_{os})$ des Spulenstroms $i_0(t)$ auf 100% normiert.

Aus Fig. 2 erkennt man, dass, wenn sich das Objekt O aus sehr großer Entfernung ($x \to -\infty$) zur Spule S hin bewegt, die Spitze des Ortsvektors A1(x) beginnend von einem Ausgangspunkt $A1(\varphi_{os})$ entlang der Ortskurve A1 wandert und, wenn das Objekt O den Spulenmittelpunkt erreicht ($x = 0$), bei maximaler Phasenverschiebung $\varphi_{max}$ den

Umkehrpunkt A1($\varphi_{max}$) erreicht. Es sei erwähnt, dass die Phasenverschiebung $\varphi(x)$ positiv ist, wenn der ferromagnetische Effekt überwiegt ($\mu_r \gg 1$, Eisen etc.), hingegen negativ, wenn der Wirbelstromeffekt überwiegt ($\mu_r \approx 1$, Buntmetalle etc.). Ist $\mu_r > 1$ (z.B. 10, rostfreie Stähle etc.) können sowohl positive als auch negative Werte für $\varphi(x)$ auftreten.

Wenn sich das Objekt O nun über den Spulenmittelpunkt (x=0) hinausbewegt, d.h. wieder von der Spule S entfernt, so bewegt sich der Ortsvektor A1(x) vom Umkehrpunkt A1($\varphi_{max}$) der Ortskurve A1 wieder zurück, um bei einem großen Objektabstand ($x \rightarrow +\infty$) idealer Weise wieder den Ausgangspunkt A1($\varphi_{os}$) der Ortskurve A1 zu erreichen. Dasselbe gilt natürlich analog für die zweite Ortskurve A2.

Um morphologische Artefakte möglichst auszuschalten, ist gemäß der Erfindung vorgesehen, Betragsmessungen der Ströme interpolierend bei diskreten Phasen (Messphasen $\varphi_M$) durchzuführen und mit entsprechenden Beträgen von Referenzproben zu vergleichen.

Für eine hohe Empfindlichkeit sollen die Messphasen $\varphi_M$ nahe der Stelle x=0 liegen, deren Zeitpunkt zusätzlich als einfache Referenz für die Objektausbringung aus dem Materialstrom 2 in einer Sortieranlage 1 verwendet werden kann, wenn die Geschwindigkeit v des Materialstroms 2 bekannt ist (siehe Fig. 6).

In weiterer Ausgestaltung der Erfindung ist vorgesehen, den maximalen Phasenverschiebungswinkel $\varphi_{max}$ zu ermitteln, der auftritt, wenn sich das Objekt an der Stelle x = 0 befindet. Der Zeitpunkt des Auftretens dieses maximalen Phasenverschiebungswinkel $\varphi_{max}$ kann ebenfalls als Referenz für die Objektausbringung aus dem Materialstrom 2 in der Sortieranlage 1 verwendet werden, da die Geschwindigkeit v des Materialstroms 2 bekannt ist.

Für einen jeweiligen vorgegebenen Messphasenwinkel $\varphi_M$ sind die Amplituden A1($\varphi_M$) bzw. A2($\varphi_M$) ein Indikator für das Material Mat1 bzw. Mat2 des jeweiligen Objekts O. Der Unterschied zwischen den Amplituden A1($\varphi_M$) bzw. A2($\varphi_M$) und damit die Empfindlichkeit der Messung ist umso größer, je näher der Messphasenwinkel $\varphi_M$ am maximalen Phasenverschiebungswinkel $\varphi_{max}$ gewählt wird. Da der maximale Phasenverschiebungswinkel $\varphi_{max}$ jedoch unter anderem von der Größe des Objekts O abhängt, darf in der Praxis der Messphasenwinkel $\varphi_M$ auch nicht zu groß gewählt werden, da er sonst mit kleinen Objekten O möglicherweise gar nicht erreicht würde. Bei großen Objekten wiederum wird der vorgegebene Messphasenwinkel $\varphi_M$ möglicherweise bereits bei einer Teilüberdeckung der Spule S durch das Objekt O erreicht, d.h. wenn $|x| > 0$. Dies ist für die Unterscheidbarkeit des Objekts O jedoch kein Nachteil.

Die Formen der Ortskurven A1, A2 hängen u. a. von folgenden Einflussgrößen ab:

- Spuleneinflussgrößen:

  - Messfrequenz $f_M$ (= Frequenz der Anregspannung bzw. des Stroms durch die Spule),
  - Primärfeldstärke $H_p$,
  - Spulendurchmesser und -form, Windungszahl der Spule,
  - konstruktiver axialer Abstand zwischen Spule und Objekt

- Materialspezifische physikalische Objekteinflussgrößen (=Messgrößen):

  - Relative magnetische Permeabilität $\mu_r$ (verantwortlich für die Erzeugung des das Primärfeld verstärkenden Sekundärfelds)
  - elektrische Leitfähigkeit $\sigma$ (verantwortlich für den Wirbelstromeffekt)

- Morphologische Objekteinflussgröße:

  - Größe, Dicke, Form, Oberflächenbeschaffenheit, Homogenität im Wirbelstrombereich, Volumen

- Störgrößen:

  - Variation des Objektabstandes, Störfelder, Rauschen, Objektbewegung, Temperatur, Nichtlinearitäten, ...

Erfindungsgemäß werden folgende Maßnahmen vorgeschlagen, um die oben erwähnten Einflussgrößen für die erfindungsgemäßen Messungen zu nutzen:

Die Messfrequenz $f_M$ wird konstant gehalten, wobei sich ein Wert zwischen 1 kHz und 1 MHz, vorzugsweise zwischen 5 und 100 kHz und am meisten bevorzugt zwischen 10 und 50 kHz bewährt hat. Die Optimierung der Frequenz geht dahin, dass die zu erwartende Eindringtiefe einerseits die Einflüsse der Oberflächenbeschaffenheit für die zu selektierenden Materialien möglichst minimiert, andererseits aber hinreichend dünne Objekte sicher erkannt werden (Dickeneinfluss wird minimiert).

Die Primärfeldstärke $H_p$ soll konstant und möglichst groß sein.

Der Spulendurchmesser d wird derart optimiert, sodass der geforderte axiale Objektabstand z von der Spule erreicht wird, aber Einflüsse von Größe und Form des Objekts minimiert werden. Um dies zu erreichen wird vorgeschlagen, den Spulendurchmesser kleiner als einen mittleren Durchmesser der zu unterscheidenden Objekte zu wählen, wobei aber zu beachten ist, dass bei kleinerem Spulendurchmesser die Empfindlichkeit der Spule abnimmt.

Die Spulenform wird empirisch mit Finite Elemente Methode (FEM)-Unterstützung optimiert.

Der axiale Objektabstand von der Spule wird konstruktiv möglichst konstant gehalten.

Morphologische Objekteinflussgrößen, insbesondere Einflüsse von Größe, Dicke, Volumen und Form der Objekte können durch das nachfolgend beschriebene erfindungsgemäße Messverfahren minimiert werden, Einflüsse der Oberflächenbeschaffenheit der Objekte werden durch konstruktive Maßnahmen (Spulenform) für ein weites Objektspektrum minimiert.

Die Einflüsse der Homogenität im Wirbelstrombereich sind derzeit noch nicht beherrschbar, sind aber für die praktische Anwendbarkeit der Erfindung vernachlässigbar.

In Bezug auf Störgrößen hat sich die erfindungsgemäße Vorrichtung als sehr störfest erwiesen.

Nunmehr wird anhand der Spannungs- und Stromdiagramme von Fig. 3 das erfindungsgemäße Signalauswerteverfahren beschrieben. Anschließend folgt eine Beschreibung einer Implementierung dieses Verfahrens in einer erfindungsgemäßen Vorrichtung zum Unterscheiden von ein elektromagnetisches Wechselfeld beeinflussenden Objekten.

Der Signalauswertung liegt eine äußerst effiziente Methode zu Grunde, bei der die Ortskurve punktweise ermittelt wird. Im einfachsten Fall braucht nur ein Punkt der Ortskurve ermittelt und ausgewertet zu werden, indem eine diskrete Messphase $\varphi_M$ vorgegeben wird und bei Erreichen dieser Messphase $\varphi_M$ der Betrag (Amplitude) $\hat{I}_M$ des Stromes $i_M(t)$ interpolierend ermittelt wird. Aus dem Wertepaar aus Messphase $\varphi_M$ und Betrag $\hat{I}_M$ kann durch Vergleich mit Referenzwerten auf das Material des Objekts O geschlossen werden.

Bei dem erfindungsgemäßen Auswerteverfahren gibt systembedingt die Anregefrequenz $f_M$ der Magnetisierungsspule S die Abtastfrequenz vor (eine Messung pro Periode). Die Anregefrequenz $f_M$ wird dabei konstant gehalten.

Zunächst wird aus dem Anregspannungsverlauf $u_e(t)$ und dem Stromverlauf $i_0(t)$ der unbedeckten Spule S bzw. des unbedeckten Serienresonanzkreises der Nulldurchgang p2 des Stromes $i_0(t)$ und damit die Offsetphase $\varphi_{os}$ des Serienresonanzkreises ermittelt. Die Nulldurchgänge der Anregspannung $u_e(t)$ sind mit dem Bezugszeichen NL bezeichnet. Diese Offsetphase $\varphi_{os}$ kann für die weiteren Betrachtungen mit 0˚ angenommen werden. Gelangt nun ein Objekt O in den Wirkungsbereich der Spule S, so ändert sich die Phase $\varphi(x)$ in Abhängigkeit von der x-Position des Objekts O und damit auch der Stromverlauf. Wenn die Phase $\varphi(x)$ von der Offsetphase $\varphi_{os}$ um einen vorgegebenen Messphasenwinkel $\varphi_M$ abweicht, so stellt sich der in Fig. 3 dargestellte Stromverlauf $i_M(t)$ ein. Die Ermittlung des Messphasenwinkels $\varphi_M$ wird über die Messung des Nulldurchgangs p5 des Stromverlaufs $i_M(t)$ mithilfe eines Nulldurchgangdetektors (Strom- bzw. Spannungskomparator) und eines Digitalzählers mit konstanter Zählfrequenz vorgenommen. Da die Anregfrequenz (Messfrequenz) $f_M$ bekannt ist, kann aus der Zeit zwischen den beiden Nulldurchgängen p2 bzw. p5 der Messphasenwinkel $\varphi_M$ errechnet werden.

Die Beträge (in der vorliegenden Beschreibung auch als Amplituden bzw. Scheitelwerte bezeichnet) der Stromverläufe $i_0(t)$ bzw. $i_M(t)$ werden mithilfe eines zu einer Signalmittellinie (hier zur Nulllinie) symmetrischen Fensterkomparators mit einer konstanten Fensterbreite $\Delta i$ errechnet, indem die Steigungen der im Nulldurchgang linearisierten sinusförmigen Stromverläufe $i_0(t)$ bzw. $i_M(t)$ bekannter Frequenz gemessen werden. Genauer gesagt, wird mithilfe des Fensterkomparators für den Stromverlauf $i_0(t)$ der Eintrittspunkt p1 in das Komparatorfenster und der Austrittspunkt p3 daraus gemessen und mithilfe eines Timers, der z.B. als digitaler Zähler konstanter Zählfrequenz implementiert ist, die Zeit $\Delta t_0$ zwischen dem Fenstereintrittspunkt p1 und dem Fensteraustrittspunkt p3 erfasst. Aufgrund des linearen Verlaufs des sinusförmigen Stromverlaufs $i_0(t)$ zwischen den Punkten p1 und p3 lässt sich aus der Fensterbreite $\Delta i$ des Fensterkomparators und der Zeit $\Delta t_0$ die Steigung des Stromverlaufs $i_0(t)$ im Nulldurchgang p2 errechnen. Dasselbe gilt analog für den Stromverlauf $i_M(t)$, für den sich ein Fenstereintrittspunkt p4 und ein Fensteraustrittspunkt p6 ergeben, wobei die verstrichene Zeit zwischen dem Auftreten der Punkte p4 bzw. p6 vom Timer mit $\Delta t_M$ ermittelt wird.

Die Steigungen und Phasenverschiebungen genügen definitionsgemäß einer Geradengleichung. Somit kann aus den gewonnenen Zählerstandpaaren leicht ein jeweiliges Wertepaar aus Amplitude und Phasenverschiebung der Stromverläufe i0(t) und $i_M(t)$ berechnet werden, wobei sich durch periodische Erfassung dieser Wertepaare für verschiedene Phasenwinkel $\varphi(x)$ die zugehörige Ortskurve A1 punktweise ergibt.

Der Scheitelwert $\hat{I}$ errechnet sich für sinusförmige Ströme mit

$$\hat{I} = \frac{1}{2 \cdot \pi \cdot f} \cdot \frac{di}{dt}$$

im Stromnulldurchgang .

Da die Frequenz der sinusförmigen Anregspannung $u_e(t)$ und damit auch die Frequenz $f_M$ des ausgewerteten

Spulenstromes $i_0(t)$ bzw. $i_M(t)$ konstant ist (lineares System), ergibt sich ein direkter Zusammenhang zwischen den Scheitelwerten $\hat{I}_0$ bzw. $\hat{I}_M$ der Spulenströme $i_0(t)$ bzw. $i_M(t)$ und dem Betrag der Steigung $\Delta i/\Delta t_0$ bzw. $1i/\Delta t_M$ der Tangente im Nulldurchgang. Für $\Delta_i \ll \hat{I}$ kann in obiger Formel der Differentialquotient di/dt durch den Differenzenquotienten

$\dfrac{\Delta i}{\Delta t}$ ersetzt werden, so dass die Formel für die Scheitelwerte $\hat{I}_0$ bzw.

$\hat{I}_M$ folgendermaßen lautet:

$$\hat{I}_0 = \frac{1}{2 \cdot \pi \cdot f_M} \cdot \frac{\Delta i}{\Delta t_0}$$

bzw.

$$\hat{I}_M = \frac{1}{2 \cdot \pi \cdot f_M} \cdot \frac{\Delta i}{\Delta t_M}$$

Im Diagramm von Fig. 3 wurde der Scheitelwert $\hat{I}_0$ auf 100% normiert und entspricht somit der Amplitude des Ortsvektors $A1(\varphi_{os})$ im Ortskurvendiagramm von Fig. 2.

Für die Phasenverschiebung $\varphi_{os}$ zwischen Anregspannung $u_e(t)$ und Spulenstrom $i_0(t)$ in gilt:

$$\varphi_{os} = 360 \cdot f_M \cdot \Delta t \quad .$$

Bei konstanter Frequenz ergibt sich naturgemäß auch hier ein direkter Zusammenhang zwischen der Phasenverschiebung und der gemessenen Zeit.

Für einfache Materialunterscheidungsaufgaben kann die Auswertung noch vereinfacht werden, indem an Stelle der Stromnulldurchgänge p2, p5 die Fenstereintrittspunkte p1, p4 oder die Fensteraustrittspunkte p3, p6 zur Phasenmessung herangezogen werden sowie auf die Approximation verzichtet wird (Fensterstrom $\Delta i \ll$ Scheitelwert der Stromamplitude $\hat{I}$) und die Zählerstände des digitalen Zählers direkt (ohne Umrechnung in Amplituden- bzw. Phasenwerte) ausgewertet werden. Es tritt bei dieser Auswertung zwar ein kleiner Messfehler auf, da dieser jedoch konstant ist, kann er bei der Auswertung berücksichtigt werden.

Für anspruchsvolle Materialunterscheidungsaufgaben können jedoch auch Methoden der Signalverarbeitung zur Auswertung der gesamten Ortskurve herangezogen werden.

Durch Vergleich mit Ortskurve von Referenzobjekten kann in einem weiten Bereich für Objekte unterschiedlicher Form, Größe und Dicke sehr zuverlässig die Metallart (el. Leitfähigkeit, rel. magn. Permeabilität) ermittelt werden.

Fig. 4 zeigt ein Blockschaltbild einer erfindungsgemäßen Vorrichtung 10 zum Unterscheiden von ein elektromagnetisches Wechselfeld beeinflussenden Objekten, in der das erfindungsgemäße Unterscheidungsverfahren mit einigen Vereinfachungen implementiert ist. In der erfindungsgemäßen Vorrichtung 10 ist eine Erregungsspule S seriell mit einer schaltbaren Kapazität C zu einem Serienresonanzkreis verbunden. Der Serienresonanzkreis wird von einem durch einen DAC 12 gesteuerten FET 11 mit einer sinusförmigen Wechselspannung $u_e(t)$ konstanter Amplitude und Frequenz, vorzugsweise seiner Eigenfrequenz, gespeist, so dass durch die Spule S und damit durch den Serienresonanzkreis ein sinusförmiger Strom $i_0(t)$ fließt, der gegenüber der Anregspannung $u_e(t)$ um einen Offset-Phasenwinkel $\varphi_{os}$ phasenversetzt ist. Die Kapazität C ist schaltbar ausgeführt, um empirisch den Offset-Phasenwinkel $\varphi_{os}$ einstellen zu können. Die Frequenz $f_M$ der Anregspannung $u_e(t)$ wurde mit 13 kHz festgelegt. Alternativ zum DAC 12 und FET 11 könnte auch ein Sinusgenerator mit Verstärker zum Einsatz kommen.

Wenn an der Spule S ein nicht dargestelltes elektrisch leitfähiges und/oder ferromagnetisches Objekt vorbeibewegt wird, ändert sich die Induktivität der Spule S und somit auch der Phasenwinkel zwischen Anregspannung $u_e(t)$ und dem Stromverlauf durch die Spule. Beispielsweise tritt bei einem definierten Messphasenwinkel $\varphi_M$ der Stromverlauf $i_M(t)$ auf. Der Strom durch den Serienresonanzkreis wird mittels eines Shuntwiderstands 13 in ein Spannungssignal $u_M(t)$ umgewandelt, das den Eingängen zweier Komparatoren 15, 16 zugeführt wird, deren Vergleichsspannungen mit -Vref und +Vref festgelegt sind. Die Komparatoren 15 und 16 bilden einen Fensterkomparator, dessen aus der Differenz aus den Vergleichsspannungen +Vref und -Vref definierte Fensterbreite der Fensterbreite $\Delta i$ des Signaldiagramms von

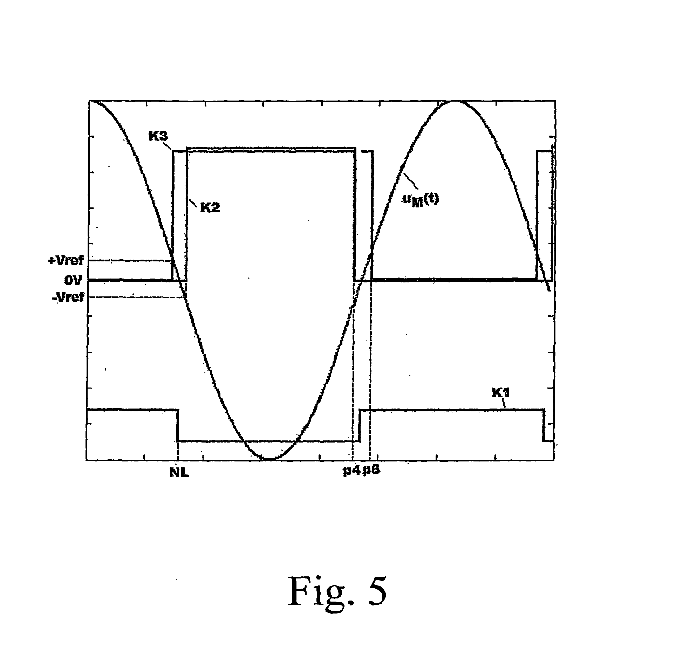

Fig. 3 entspricht. Einem weiteren Komparator 14 wird die Anregspannung $u_e(t)$ zugeführt, seine Vergleichsspannung ist auf 0V festgelegt, so dass er den Nulldurchgang NL der Anregspannung $u_e(t)$ erfasst. Das Ausgangssignal K1 des Komparators 14 in Abhängigkeit der Anregspannung $u_e(t)$ ist im Signaldiagramm von Fig. 5 dargestellt. Weiters sind im Signaldiagramm von Fig. 5 die Vergleichsspannungen -Vref und +Vref der zwei Komparatoren 15, 16 sowie das Ausgangssignal K2 des Komparators 15 und das Ausgangssignal K3 des Komparators 16 dargestellt.

Der Komparator 14 startet beim Nulldurchgang NL der Anregspannung $U_e(t)$ einen ersten Zähler 18 und einen zweiten Zähler 19. Beide Zähler 18, 19 sind negativ flankengetriggert. Der Komparator 15 stoppt zum Zeitpunkt p4 den zweiten Zähler 19, wenn das Eingangssignal $u_M(t)$ seinen Vergleichsspannungswert -Vref überschreitet, d.h. in das Komparatorfenster eintritt. Der Komparator 16 stoppt zum Zeitpunkt p6 den ersten Zähler 18, wenn das Eingangssignal seinen Vergleichsspannungswert +Vref überschreitet, d.h. aus dem Komparatorfenster austritt. Die beiden Zähler 18, 19 sind als digitale Zähler mit konstanter Zählfrequenz ausgebildet, so dass sich aus der Differenz zwischen den beiden Zählerständen die Zeitdifferenz $\Delta t_M$ ableiten lässt, vergleiche dazu Fig. 3. Im vorliegenden Ausführungsbeispiel sind die beiden Zähler 18, 19 in einen Microcontroller 17 integriert. Aus der Zeitdifferenz $\Delta t_M$ und der bekannten Frequenz des Signals $u_M(t)$ lässt sich die Steigung des Signals $u_M(t)$ im Nulldurchgang p5 (siehe Fig. 3) ermitteln und aus der Steigung die Amplitude des Signals $u_M(t)$ errechnen, wie oben anhand der Formeln beschrieben wurde. In einer Variante der vorliegenden Ausführungsform der erfindungsgemäßen Vorrichtung könnte der Komparator 15 einen Zähler (18 oder 19) starten und der Komparator 16 den Zähler stoppen. Aus dem Zählerstand ist unmittelbar die Zeitdauer $\Delta t_M$ ableitbar, die der Spulenstrom $i_M(t)$ zum Durchschreiten des Komparatorfensters $\Delta i$ benötigt, woraus wiederum der Scheitelwert errechenbar ist.

Im vorliegenden Ausführungsbeispiel wurden jedoch zur Signalauswertung einige Vereinfachungen getroffen: So wird die Phase zwischen den Signalen $u_e(t)$ und $u_M(t)$ mit einem kleinen, aber konstanten Fehler aus der Differenz zwischen den Zeitpunkten NL und p4 abgeleitet. Weiters wird die Amplitude des Signals $u_M(t)$ nicht direkt aus den obigen Formeln errechnet, sondern der Zählwert des zweiten Zählers 19 wird als Index einer Referenzwerttabelle benutzt, die in einem EEPROM 21 abgelegt ist und für jeden Indexwert Ref_1 - Ref_5 einen damit assoziierten Referenz-Schwellwert Lim_1 - Lim_5 besitzt, mit dem in einem digitalen Komparator 23 der Zählwert des ersten Zählers 18 verglichen wird. Aus dem Über- oder Unterschreiten des jeweils benutzten Referenz-Schwellwerts Lim_1 - Lim_5 schließt eine Klassifikations- und Objektlängenbestimmungseinheit 24 auf das Material des Objekts. Somit werden bei dieser Ausgestaltung der erfindungsgemäßen Vorrichtung 10 die Zählerstände des ersten und zweiten Zählers 18, 19 direkt, d.h. ohne vorherige Umrechnung in Amplituden- bzw. Phasenwerte ausgewertet. Durch das Vorsehen der Referenzwerttabelle wird der Tatsache Rechnung getragen, dass es für unterschiedliche Materialentscheidungen (VA-NE, A1-Cu, ...) verschiedene optimale Punkte zur Vermessung gibt. Da sich jedes Objekt der Spule annähert, gibt es bei jeder Sampleperiode einen neuen Zählerstand im zweiten Zähler 19 und damit einen neuen Referenz- und Limes-Wert.

Der Microcontroller 17 umfasst weiters einen Timer 20 und ein RAM 22, wobei die Zählwerte des Timers 20 das Auslesen zugehöriger Tabellenwerte aus dem RAM 22 an den DAC steuern, die für die Erzeugung der sinusförmigen Spannung $u_e(t)$ sorgen.

In Fig. 6 ist schematisch eine erfindungsgemäße Sortieranlage 1 dargestellt. Diese umfasst ein Förderband 3, auf dem sich mit konstanter Geschwindigkeit v ein Materialstrom 2 bewegt, in dem Objekte O enthalten sind, die aufgrund ihrer Leitfähigkeit und/oder ferromagnetischen Eigenschaften erkannt und aussortiert werden sollen. Dazu ist unterhalb des Förderbands 3 eine erfindungsgemäße Vorrichtung 10 zum Unterscheiden der Objekte O angeordnet. Die Spule S eines Resonanzkreises der Vorrichtung 10 ist so angeordnet, dass ihre Spulenachse SA in einem rechten Winkel zur Förderrichtung (x-Richtung) des Materialstroms 2 steht. Weiters steht die Spule S in einem - in Richtung der Spulenachse SA gemessenen - Abstand z zum Materialstrom 2. Der Durchmesser d der Spule S ist so dimensioniert, dass er kleiner ist als ein mittlerer Durchmesser D der zu unterscheidenden Objekte O. Wenn sich die Objekte O in x-Richtung über den Spulenmittelpunkt (Spulenachse SA) bewegen, stellt sich ein materialcharakteristischer Verlauf der Betrags- und Phasenänderungen des Spulenstromes in Abhängigkeit von der x-Position des Objekts O zur Spule S ein, der in der Vorrichtung 10 ausgewertet wird. In Abhängigkeit vom Ergebnis der Auswertung steuert die Vorrichtung 10 eine Objektausbringeinheit 4 an, beispielsweise eine Luftdüse, die die Objekte O aus dem Materialstrom 2 ausbringt. Im dargestellten Ausführungsbeispiel gelangt der sortierte Materialstrom 2 in einen Behälter 5. In der Praxis wird natürlich eine Vielzahl von Spulen quer über die Breite des Förderbands 3 angeordnet, wobei die Spulenabstände voneinander so gewählt werden, dass kein Objekt O zwischen den Erfassungsbereichen von Spulen hindurchgelangen kann, ohne bemerkt zu werden. Anstelle eines Förderbands 3 kann beispielsweise auch eine Rutsche vorgesehen sein.

**Patentansprüche**

1. Verfahren zum Unterscheiden von ein elektromagnetisches Wechselfeld beeinflussenden Objekten (O), insbesondere Metallobjekten, mittels einer Spule (S), die an einer Förderstrecke (3) angeordnet ist, auf der ein Materialstrom (2) mit einer vorgegebenen Geschwindigkeit (v) in eine Richtung (x) bewegt wird, wobei der Materialstrom leitfähige und/oder ferromagnetische Objekte (O) aufweisen kann, umfassend das Erzeugen eines elektromagnetischen Wechselfeldes mittels Anregung der Spule (S) mit einer sinusförmigen Spannung ($u_e$(t)) konstanter Frequenz ($f_M$), das Erfassen einer durch ein Objekt (O) verursachten Impedanzänderung der Spule S durch Ermitteln zumindest eines Wertepaars aus einem Scheitelwert ($\hat{I}_M$) eines sinusförmigen Spulenstromes ($i_M$(t)) und einer Phasenverschiebung ($\varphi_M$) zwischen dem Spulenstrom ($i_M$(t)) und der Anregspannung ($u_e$(t)), und das Bestimmen des Materials (Mat1, Mat2) des Objekts (O) durch Vergleichen des zumindest einen Wertepaars aus einem Scheitelwert ($\hat{I}_M$) und einer Phasenverschiebung ($\varphi_M$) des sinusförmigen Spulenstromes ($i_M$(t)) mit Referenzwerten, **dadurch gekennzeichnet, dass** die Scheitelwerte ($\hat{I}_M$) des sinusförmigen Spulenstromes ($i_M$(t)) bei zumindest einem vorbestimmten Messphasenwinkel ($\varphi_M$) mithilfe eines Fensterkomparators mit einer konstanten, vorzugsweise einstellbaren, Fensterbreite ($\Delta i$) errechnet werden, wobei die Zeit ($\Delta t_M$) zwischen dem Fenstereintrittspunkt (p4) und dem Fensteraustrittspunkt (p6) des Spulenstromes ($i_M$(t)) gemessen und aus der Fensterbreite ($\Delta i$) des Fensterkomparators und der gemessenen Zeit ($\Delta t_M$) die Steigung des Stromverlaufs ($i_M$(t)) errechnet sowie aus der Steigung des sinusförmigen Stromverlaufs $i_M$(t) und seiner bekannten Frequenz ($f_M$) der Scheitelwert ($\hat{I}_M$) errechnet wird.

2. Verfahren nach Anspruch 1, **dadurch gekennzeichnet, dass** die Werte des Eintrittspunkts und des Austrittspunkts des Fensters des Fensterkomparators symmetrisch zu einer Signalmittellinie, insbesondere Nulllinie, des Spulenstroms festgelegt werden.

3. Verfahren nach Anspruch 1 oder 2, **dadurch gekennzeichnet, dass** zur Materialbestimmung des Objekts (O) zumindest ein bei einer diskreten Messphase ($\varphi_M$) ermittelter Scheitelwert ($\hat{I}_M$) mit entsprechenden Scheitelwerten von Referenzproben verglichen wird.

4. Verfahren nach einem der vorhergehenden Ansprüche, **dadurch gekennzeichnet, dass** zumindest eine Messphase ($\varphi_M$) nahe einem bei größter Annäherung des Objekts (O) an die Spule (S) auftretenden maximalen Phasenverschiebungswinkel ($\varphi_{max}$) gewählt wird, wobei jedoch vorzugsweise der Abstand zwischen dem Messphasenwinkel ($\varphi_M$) und dem
maximalen Phasenverschiebungswinkel ($\varphi_{max}$) zumindest so groß gewählt wird, dass er auch mit den kleinsten im Materialstrom (2) auftretenden Objekten (O) erreicht wird.

5. Verfahren nach einem der vorhergehenden Ansprüche, **dadurch gekennzeichnet, dass** der Zeitpunkt des Erreichens des Messphasenwinkels ($\varphi_M$) bei bekannter Geschwindigkeit (v) des Materialstroms (2) als Referenzzeitpunkt für die Ausbringung des Objekts (O) aus dem Materialstrom (2) verwendet wird.

6. Verfahren nach einem der vorhergehenden Ansprüche, **dadurch gekennzeichnet, dass** der maximale Phasenverschiebungswinkel ($\varphi_{max}$) bestimmt wird.

7. Verfahren nach einem der vorhergehenden Ansprüche, **dadurch gekennzeichnet, dass** der Zeitpunkt des Erreichens des maximalen Phasenverschiebungswinkel ($\varphi_{max}$) bei bekannter Geschwindigkeit (v) des Materialstroms (2) als Referenzzeitpunkt für die Ausbringung des Objekts (O) aus dem Materialstrom (2) verwendet wird.

8. Verfahren nach einem der vorhergehenden Ansprüche, **dadurch gekennzeichnet, dass** durch periodisches Erfassen von Wertepaaren aus Scheitelwert und Phasenverschiebung der Stromverläufe ($i_0$(t), $i_M$(t)) für verschiedene Phasenwinkel $\varphi$(x) die zugehörige Ortskurve (A1, A2) punktweise aufgenommen und zur Auswertung durch Vergleich mit Referenzortskurven herangezogen wird.

9. Verfahren nach einem der vorhergehenden Ansprüche, **dadurch gekennzeichnet, dass** zunächst aus dem Anregspannungsverlauf $u_e$(t) und dem Stromverlauf $i_0$(t) der Spule S im von Objekten (O) unbeeinflussten Zustand die Offsetphase ($\varphi_{os}$) ermittelt wird und in weiterer Folge die Messphasenwinkel ($\varphi_M$) der Stromverläufe ($i_M$(t)) auf die Offsetphase ($\varphi_{os}$) bezogen werden.

10. Verfahren nach einem der vorhergehenden Ansprüche, **dadurch gekennzeichnet, dass** die Anreg- bzw. Messfrequenz $f_M$ auf einen Wert zwischen 1 kHz und 1 MHz, vorzugsweise zwischen 5 und 100 kHz und am meisten bevorzugt zwischen 10 und 50 kHz eingestellt wird.

11. Verfahren nach einem der vorhergehenden Ansprüche, **dadurch gekennzeichnet, dass** der Spulendurchmesser (d) kleiner als ein mittlerer Durchmesser (D) der zu unterscheidenden Objekte (O) gewählt wird.

12. Vorrichtung zum Unterscheiden von ein elektromagnetisches Wechselfeld beeinflussenden Objekten (O), insbesondere Metallobjekten, mit einer Spannungsquelle (11, 12) zur Erzeugung einer sinusförmigen Anregspannung ($u_e(t)$) konstanter Frequenz ($f_M$), einer Spule (S), der die Anregspannung ($u_e(t)$) zur Erzeugung eines elektromagnetischen Wechselfeldes zugeführt wird, Rechenmittel (17) zum Erfassen einer durch ein Objekt (O) verursachten Impedanzänderung der Spule (S) durch Ermitteln zumindest eines Wertepaars aus einem Scheitelwert ($\hat{I}_M$) eines durch die Spule (S) fließenden sinusförmigen Spulenstromes ($i_M(t)$) und einer Phasenverschiebung ($\varphi_M$) zwischen dem Spulenstrom ($i_M(t)$) und der Anregspannung ($u_e(t)$), und Mittel (24) zum Bestimmen des Materials (Mat1, Mat2) des Objekts (O) durch Vergleichen des zumindest einen Wertepaars aus einem Scheitelwert ($\hat{I}_M$) und einer Phasenverschiebung ($\varphi_M$) des sinusförmigen Spulenstromes ($i_M(t)$) mit Referenzwerten, **gekennzeichnet durch** einen Fensterkomparator (15, 16) mit einer konstanten, vorzugsweise einstellbaren, Fensterbreite ($\Delta i$), dem der Spulenstrom ($i_M(t)$) bzw. ein dazu proportionales Spannungssignal $u_M(t)$ zugeführt wird, Zeiterfassungsmittel (18, 19) zur Messung der Zeitdauer ($\Delta t_M$), die der Spulenstrom ($i_M(t)$) benötigt, um das Komparatorfenster ($\Delta i$) zu durchlaufen, wobei die Rechenmittel (17) dazu ausgebildet sind, bei zumindest einem vorbestimmten Messphasenwinkel ($\varphi_M$) aus der Zeitdauer ($\Delta t_M$) und der Fensterbreite ($\Delta i$) des Fensterkomparators (15, 16) die Steigung des Stromverlaufs ($i_M(t)$) zu errechnen sowie aus der Steigung des sinusförmigen Stromverlaufs $i_M(t)$ und seiner bekannten Frequenz ($f_M$) den Scheitelwert ($\hat{I}_M$) zu errechnen.

13. Vorrichtung nach Anspruch 12, **gekennzeichnet durch** einen Strom/Spannungswandler, vorzugsweise ein Shuntwiderstand (13), zur Umwandlung des Spulenstromes ($i_M(t)$) in ein proportionales Spannungssignal $U_M(t)$.

14. Vorrichtung nach Anspruch 12 oder 13, **dadurch gekennzeichnet, dass** die Spule (S) mit einer, vorzugsweise veränderbaren, Kapazität (C) in einen Resonanzkreis geschaltet ist.

15. Vorrichtung nach einem der Ansprüche 12 bis 14, **dadurch gekennzeichnet, dass** die Werte des Eintrittspunkts (-Vref) und des Austrittspunkts (+Vref) des Fensters des Fensterkomparators (15, 16) symmetrisch zu einer Signalmittellinie, insbesondere Nulllinie, des Spulenstroms festgelegt sind.

16. Vorrichtung nach einem der Ansprüche 12 bis 15, **gekennzeichnet durch** einen Komparator (14) zur Erfassung des Nulldurchgangs (NL) der Anregspannung ($u_e(t)$).

17. Vorrichtung nach einem der Ansprüche 12 bis 16, **dadurch gekennzeichnet, dass** die Zeiterfassungsmittel als digitale Zähler (18, 19) mit konstanter Zählfrequenz ausgebildet sind.

18. Vorrichtung nach Anspruch 17, **dadurch gekennzeichnet, dass** das Ausgangssignal (K1) des Nulldurchgangs-Komparators (14) die Zähler (18, 19) startet und der Fensterkomparator (15, 16) bei Eintritt des Spulenstroms ($i_M(t)$) in das Komparatorfenster einen Zähler (19) stoppt und bei Austritt des Spulenstroms ($i_M(t)$) aus dem Komparatorfenster einen weiteren Zähler (18) stoppt.

19. Vorrichtung nach Anspruch 18, **dadurch gekennzeichnet, dass** aus der Differenz der beiden Zählerstände die Zeitdauer ($\Delta t_M$) abgeleitet wird, die der Spulenstrom ($i_M(t)$) für das Durchschreiten des Komparatorfensters ($\Delta i$) benötigt.

20. Vorrichtung nach Anspruch 17, **dadurch gekennzeichnet, dass** der Fensterkomparator (15, 16) bei Eintritt des Spulenstroms ($i_M(t)$) in das Komparatorfenster einen Zähler startet und bei Austritt des Spulenstroms ($i_M(t)$) aus dem Komparatorfenster den Zähler stoppt.

21. Vorrichtung nach einem der Ansprüche 12 bis 20, **dadurch gekennzeichnet, dass** die Rechenmittel (17) dazu ausgebildet sind, zur Materialbestimmung des Objekts (O) zumindest einen bei einer diskreten Messphase ($\varphi_M$) ermittelten Scheitelwert ($\hat{I}_M$) mit entsprechenden Scheitelwerten von Referenzproben zu vergleichen.

22. Vorrichtung nach Anspruch 18, **dadurch gekennzeichnet, dass** die Rechenmittel (17) dazu ausgebildet sind, den Zählwert des zweiten Zählers (19) als Index einer Referenzwerttabelle zu benutzen und für jeden Indexwert (Ref_1 - Ref_5) einen damit assoziierten Referenz-Schwellwert (Lim_1 - Lim_5) auszulesen und mit dem Zählwert des ersten Zählers (18) zu vergleichen und aus dem Über- oder Unterschreiten des jeweils benutzten Referenz-Schwellwerts (Lim_1 - Lim_5) auf das Material des Objekts (O) zu schließen.

23. Vorrichtung nach einem der Ansprüche 12 bis 22, **dadurch gekennzeichnet, dass** die Anregspannung ($u_e(t)$) auf einen Wert zwischen 1 kHz und 1 MHz, vorzugsweise zwischen 5 und 100 kHz und am meisten bevorzugt zwischen 10 und 50 kHz eingestellt ist.

24. Vorrichtung nach einem der Ansprüche 12 bis 23, **dadurch gekennzeichnet, dass** in jeder Periode der Anregsspannung ($u_e(t)$) ein Messzyklus ausgeführt wird.

25. Sortieranlage mit einer Fördereinrichtung (3), auf dem mit bekannter Geschwindigkeit v ein Materialstrom (2) bewegbar ist, in dem Objekte O enthalten sind, die aufgrund ihrer Leitfähigkeit und/oder ferromagnetischen Eigenschaften erkannt und mittels einer Objektausbringeinheit (4) aussortiert werden sollen, **gekennzeichnet durch** zumindest eine Vorrichtung (10) zum Unterscheiden der Objekte O nach einem der Ansprüche 12 bis 24, wobei die Spule (S) nahe der Fördereinrichtung (3) angeordnet ist, so dass sich in Förderrichtung (x-Richtung) des Materialstroms 2 bewegende Objekte (O) eine materialcharakteristische Impedanzänderung der Spule (S) hervorrufen, die von der Vorrichtung (10) detektiert wird, wobei die Vorrichtung (10) die Objektausbringeinheit (4) ansteuert.

**Claims**

1. A process for differentiating objects (O) influencing an electromagnetic alternating field, in particular metal objects, using a coil (S) arranged on a conveying route (3) on which a material stream (2) is moved in one direction (x) at a predetermined speed (v), wherein the material stream can comprise conductive and/or ferromagnetic objects (O), comprising generating an electromagnetic alternating field by exciting the coil (S) with a sinusoidal voltage ($u_e(t)$) of a constant frequency ($f_M$), detecting an impedance change in the coil S, which has been caused by an object (O), by determining at least one pair of values from a peak value ($\hat{I}_M$) of a sinusoidal coil current ($i_M(t)$) and a phase shift ($\varphi_M$) between the coil current ($i_M(t)$) and the excitation potential ($u_e(t)$), and determining the material (Mat1, Mat2) of the object (O) by comparing the at least one pair of values from a peak value ($\hat{I}_M$) and a phase shift ($\varphi_M$) of the sinusoidal coil current ($i_M(t)$) with reference values, **characterized in that** the peak values ($\hat{I}_m$) of the sinusoidal coil current ($i_M(t)$) are calculated at at least one predetermined measuring phase angle ($\varphi_M$) with the aid of a window comparator having a constant, preferably adjustable, window width ($\Delta i$), wherein the time ($\Delta t_M$) between the window inlet point (p4) and the window outlet point (p6) of the coil current ($i_M(t)$) is measured and the gradient of the current profile ($i_M(t)$) is calculated from the window width ($\Delta i$) of the window comparator and the measured time ($\Delta t_M$) and the peak value ($\hat{I}_M$) is calculated from the gradient of the sinusoidal current profile $i_M(t)$ and its known frequency ($f_M$).

2. A process according to claim 1, **characterized in that** the values of the inlet point and the outlet point of the window of the window comparator are arranged symmetrically to a signal centre line, in particular zero line, of the coil current.

3. A process according to claim 1 or 2, **characterized in that** at least one peak value ($\hat{I}_M$) determined in a discrete measuring phase ($\varphi_M$) is compared to corresponding peak values of reference samples for determining the material of the object (O).

4. A process according to any of the preceding claims, **characterized in that** at least one measuring phase ($\varphi_M$) near a maximum angle of phase difference ($\varphi_{max}$), which occurs when the object (O) comes closest to the coil (S), is selected, wherein, however, the distance between the measuring phase angle ($\varphi_M$) and the maximum angle of phase difference ($\varphi_{max}$) is preferably chosen to be at least so large that it is achieved also with the smallest objects (O) occurring in the material stream (2).

5. A process according to any of the preceding claims, **characterized in that** the moment of achieving the measuring phase angle ($\varphi_M$) with a known speed (v) of the material stream (2) is used as a reference moment for discharging the object (O) from the material stream (2).

6. A process according to any of the preceding claims, **characterized in that** the maximum angle of phase difference ($\varphi_{max}$) is determined.

7. A process according to any of the preceding claims, **characterized in that** the moment of achieving the maximum angle of phase difference ($\varphi_{max}$) with a known speed (v) of the material stream (2) is used as a reference moment for discharging the object (O) from the material stream (2).

8. A process according to any of the preceding claims, **characterized in that** by periodically detecting pairs of values from the peak value and phase shift of the current profiles ($i_0(t)$, $i_M(t)$), the respective locus curve (A1, A2) is received point by point for different phase angles $\varphi(x)$ and used for evaluation via comparison with reference locus curves.

9. A process according to any of the preceding claims, **characterized in that**, first of all, the offset phase ($\varphi_{os}$) is

determined from the excitation potential distribution $u_e(t)$ and the current profile $i_0(t)$ of the coil S in a condition which is unaffected by objects (O) and subsequently the measuring phase angles ($\varphi_M$) of the current profiles ($i_M(t)$) are related to the offset phase ($\varphi_{os}$).

10. A process according to any of the preceding claims, **characterized in that** the excitation or measuring frequency $f_M$, respectively, is adjusted to a value ranging between 1 kHz and 1 MHz, preferably between 5 and 100 kHz and most preferably between 10 and 50 kHz.

11. A process according to any of the preceding claims, **characterized in that** the coil diameter (d) is chosen to be smaller than an average diameter (D) of the objects (O) to be differentiated.

12. A device for differentiating objects (O) influencing an electromagnetic alternating field, in particular metal objects, comprising a voltage source (11, 12) for generating a sinusoidal excitation potential ($u_e(t)$) of a constant frequency ($f_M$), a coil (S) which is supplied with the excitation potential ($u_e(t)$) for generating an electromagnetic alternating field, calculating means (17) for detecting an impedance change in the coil (S), which has been caused by an object (O), by determining at least one pair of values from a peak value ($\hat{I}_m$) of a sinusoidal coil current ($i_M(t)$) flowing through the coil (S) and a phase shift ($\varphi_M$) between the coil current ($i_M(t)$) and the excitation potential ($u_e(t)$), and means (24) for determining the material (Mat1, Mat2) of the object (O) by comparing the at least one pair of values from a peak value ($\hat{I}_M$) and a phase shift ($\varphi_M$) of the sinusoidal coil current ($i_M(t)$) with reference values, **characterized by** a window comparator (15, 16) having a constant, preferably adjustable, window width ($\Delta i$) which is supplied with the coil current ($i_M(t)$) and, respectively, a voltage signal $u_M(t)$ proportional thereto, time recording means (18, 19) for measuring the length of time ($\Delta t_M$) which the coil current ($i_M(t)$) needs in order to pass through the comparator window ($\Delta i$), with the calculating means (17) being designed for calculating the gradient of the current profile ($i_M(t)$) from the length of time ($\Delta t_m$) and the window width ($\Delta i$) of the window comparator (15, 16) at at least one predetermined measuring phase angle ($\varphi_M$) as well as for calculating the peak value ($\hat{I}_m$) from the gradient of the sinusoidal coil current $i_M(t)$ and its known frequency ($f_M$).

13. A device according to claim 12, **characterized by** a current/voltage transformer, preferably a shunt resistor (13), for converting the coil current ($i_M(t)$) into a proportional voltage signal $U_M(t)$.

14. A device according to claim 12 or 13, **characterized in that** the coil (S) is connected with a - preferably variable - capacitance (C) into an oscillating circuit.

15. A device according to any of claims 12 to 14, **characterized in that** the values of the inlet point (-Vref) and the outlet point (+Vref) of the window of the window comparator (15, 16) are arranged symmetrically to a signal centre line, in particular zero line, of the coil current.

16. A device according to any of claims 12 to 15, **characterized by** a comparator (14) for detecting the zero crossing (NL) of the excitation potential ($u_e(t)$).

17. A device according to any of claims 12 to 16, **characterized in that** the time recording means are designed as digital counters (18, 19) with a constant counting frequency.

18. A device according to claim 17, **characterized in that** the output signal (K1) of the zero-crossing comparator (14) starts the counters (18, 19) and the window comparator (15, 16) stops a counter (19) when the coil current ($i_M(t)$) enters into the comparator window and stops a further counter (18) when the coil current ($i_M(t)$) leaves the comparator window.

19. A device according to claim 18, **characterized in that**, from the difference of the two counts, the length of time ($\Delta t_M$) is derived which the coil current ($i_M(t)$) needs in order to pass through the comparator window ($\Delta i$).

20. A device according to claim 17, **characterized in that** the window comparator (15, 16) starts a counter when the coil current ($i_M(t)$) enters into the comparator window and stops the counter when the coil current ($i_M(t)$) leaves the comparator window.

21. A device according any of claims 12 to 20, **characterized in that** the calculating means (17) are designed for comparing at least one peak value ($\hat{I}_M$) determined in a discrete measuring phase ($\varphi_M$) to corresponding peak values of reference samples for determining the material of the object (O).

22. A device according to claim 18, **characterized in that** the calculating means (17) are designed for using the counted measurand of the second counter (19) as an index of a reference value table and for reading out, for each index value (Ref_1 - Ref_5), a reference threshold value (Lim_1 - Lim_5) associated therewith and for comparing it to the counted measurand of the first counter (18) and for inferring the material of the object (O) from exceeding or falling below the reference threshold value (Lim_1 - Lim_5) used in each case.

23. A device according to any of claims 12 to 22, **characterized in that** the excitation potential ($u_e$(t)) is adjusted to a value ranging between 1 kHz and 1 MHz, preferably between 5 and 100 kHz and most preferably between 10 and 50 kHz.

24. A device according to any of claims 12 to 23, **characterized in that** a measuring cycle is performed in each period of the excitation potential ($u_e$(t)).

25. A sorting plant comprising a conveying means (3) on which a material stream (2) is movable at a constant speed v in which objects O are contained which are supposed to be identified based on their conductivity and/or ferromagnetic properties and sorted out by means of an object discharging unit (4), **characterized by** at least one device (10) for differentiating the objects 0 according to any of claims 12 to 24, wherein the coil (S) is arranged close to the conveying means (3) so that objects (O) moving in the conveying direction (x-direction) of the material stream 2 will cause a material characteristic impedance change in the coil (S), which is detected by the device (10), with the device (10) activating the object discharging unit (4).

## Revendications

1. Procédé pour différencier des objets (O), en particulier des objets métalliques, qui influencent un champ électromagnétique alternatif, au moyen d'une bobine (S) qui est agencée sur un trajet de convoyage (3) sur lequel se déplacent un flux de matériau (2) avec une vitesse donnée (v) dans une direction (x), ledit flux de matériau pouvant présenter des objets (O) conducteurs et/ou ferromagnétiques, le procédé comprenant la génération d'un champ électromagnétique alternatif par excitation de la bobine (S) avec une tension sinusoïdale ($u_e$(t)) de fréquence cons-tante ($f_M$), la détection d'une variation d'impédance provoquée par un objet (O) dans la bobine (S) par détermination d'au moins une paire de valeurs constituée d'une valeur maximum ($i_M$) d'un courant de bobine sinusoïdal ($i_M$(t)) et d'un décalage de phase ($\phi_M$) entre le courant de bobine ($i_M$(t)) et la tension d'excitation ($u_e$(t)), et la détermination du matériau (Mat1, Mat2) de l'objet (O) par comparaison de ladite au moins une paire de valeurs constituée d'une valeur maximum ($i_M$) et d'un décalage de phase ($\phi_M$) du courant de bobine sinusoïdal ($i_M$(t)) avec des valeurs de référence,
**caractérisé en ce que** les valeurs maximum ($i_M$) du courant de bobine sinusoïdal ($i_M$(t)) sont calculées, à au moins un angle de phase mesuré prédéterminé ($f_M$) à l'aide d'un comparateur à fenêtre avec une largeur de fenêtre constante ($\Delta i$), de préférence réglable, et le temps ($\Delta t_M$) entre le point d'entrée (p4) de la fenêtre et le point de sortie (p6) de la fenêtre, du courant de bobine ($i_M$(t)), est mesuré et on calcule, à partir de la largeur ($\Delta i$) de fenêtre du comparateur à fenêtre et à partir du temps mesuré ($\Delta t_M$), la pente de l'évolution du courant ($i_M$(t)), et on calcule la valeur maximum ($i_M$) à partir de la pente du tracé sinusoïdal ($i_M$(t)) du courant et de sa fréquence connue ($f_M$).

2. Procédé selon la revendication 1, **caractérisé en ce que** les valeurs du point d'entrée et du point de sortie de la fenêtre du comparateur à fenêtre sont déterminées de manière symétrique par rapport à une ligne de signal médiane, en particulier une ligne nulle, du courant de bobine.

3. Procédé selon la revendication 1 ou 2, **caractérisé en ce que**, pour la détermination du matériau de l'objet (O), on compare au moins une valeur maximum ($I_M$) déterminée lors d'une mesure de phase discrète (fM), avec des valeurs maximum correspondantes d'échantillons de référence.

4. Procédé selon l'une des revendications précédentes, **caractérisé en ce que** ladite au moins une phase de mesure ($\phi_M$) est choisie à proximité d'un angle de décalage de phase maximum ($\phi$max) qui se produit lors du plus grand rapprochement de l'objet (O) vers la bobine (8), et la distance entre l'angle de phase de mesure ($\phi_M$) et l'angle de décalage de phase maximum ($\phi$max) est cependant de préférence choisi au moins aussi grand qu'il est atteint également avec les plus petits objets (O) qui apparaissent dans le flux de matériau (2).

5. Procédé selon l'une des revendications précédentes, **caractérisé en ce que** l'instant où l'on atteint l'angle de phase de mesure ($\phi_M$) pour une vitesse connue (v) du flux de matériau (2) est utilisé comme instant de référence pour la sortie de l'objet (O) hors du flux de matériau (2).

6. Procédé selon l'une des revendications précédentes, **caractérisé en ce que** l'angle de décalage de phase maximum ($\phi$max) est déterminé.

7. Procédé selon l'une des revendications précédentes, **caractérisé en ce que** l'instant où l'on atteint l'angle de décalage de phase maximum ($\phi$max) pour une vitesse connue (v) du flux de matériau (2) est utilisé comme instant de référence pour la sortie de l'objet (O) hors du flux de matériau (2).

8. Procédé selon l'une des revendications précédentes, **caractérisé en ce que**, par détection périodique de paires de valeurs constituées de la valeur maximum et du décalage de phase des tracés du courant ($i_O(t)$, $i_M(t)$) pour différents angles de phase ($\phi(x)$), on enregistre point par point la courbe locale associée (A1, A2) et on l'utilise pour l'évaluation par comparaison avec des courbes locales de référence.

9. Procédé selon l'une des revendications précédentes, **caractérisé en ce que** l'on détermine tout d'abord, à partir du tracé de la tension d'excitation ($u_e(t)$) et de l'évolution du courant ($i_o(t)$) de la bobine (8) dans l'état non influencé par des objets (O), la phase de décalage ($\phi$os) et dans une autre succession, on obtient l'angle de phase de mesure ($\phi_M$) des tracés du courant ($i_M(t)$) sur la phase de décalage ($\phi$os).

10. Procédé selon l'une des revendications précédentes, **caractérisé en ce que** la fréquence d'excitation ou de mesure ($f_M$) est réglée à une valeur entre 1 kHz et 1 MHz, de préférence entre 5 et 100 kHz, et de la façon la plus préférée entre 10 et 50 kHz.

11. Procédé selon l'une des revendications précédentes, **caractérisé en ce que** le diamètre de la bobine (d) est choisi inférieur à un diamètre moyen (D) des objets à distinguer (O).

12. Procédé pour différencier des objets (O), en particulier des objets métalliques, qui influencent un champ alternatif électromagnétique, comprenant une source de tension (11, 12) pour générer une tension d'excitation de forme sinusoïdale ($u_e(t)$) de fréquence constante ($f_M$), une bobine (S), à laquelle est alimentée la tension d'excitation ($u_e$ (t)) pour générer un champ alternatif électromagnétique, des moyens de calcul (17) pour constater une variation d'impédance de la bobine (S) provoquée par un objet (O), par détermination d'au moins une paire de valeurs constituée d'une valeur maximum ($i_M$) d'un courant de bobine ($i_M(t)$) de forme sinusoïdale qui s'écoule à travers la bobine (S) et d'un décalage de phase ($\phi$M) entre le courant de bobine ($i_M(t)$) et la tension d'excitation ($u_e(t)$), et des moyens (24) pour déterminer le matériau (Mat1, Mat2) de l'objet (O) par comparaison de ladite au moins une paire de valeurs constituée d'une valeur maximum ($i_M$) et d'un décalage de phase ($\phi$M) du courant de bobine sinusoïdal ($i_M(t)$) avec des valeurs de référence,
**caractérisé par** un comparateur à fenêtre (15, 16) avec une largeur de fenêtre constante ($\Delta$i), de préférence réglable, auquel est amené le courant de bobine ($i_M(t)$) ou respectivement un signal de tension proportionnel à celui-ci ($u_M(t)$), des moyens de détection de temps (18, 19) pour mesurer la durée ($\Delta t_M$) dont le courant de bobine ($i_M(t)$) a besoin pour traverser la fenêtre de comparateur ($\Delta$i), et dans lequel les moyens de calcul (17) sont réalisés pour calculer, pour au moins un angle de phase de mesure prédéterminé ($\phi_M$), à partir de la durée ($\Delta t_M$) et de la largeur de fenêtre ($\Delta$i) du comparateur à fenêtre (15, 16), la pente du tracé du courant ($i_M(t)$), ainsi que pour calculer la valeur maximum ($i_M$) à partir de la pente du tracé sinusoïdal du courant ($i_M(t)$) et de sa fréquence connue ($f_M$).

13. Dispositif selon la revendication 12, **caractérisé par** un convertisseur courant/tension, de préférence une résistance de shunt (13), pour convertir le courant de bobine ($i_M(t)$) en un signal de tension proportionnel ($U_M(t)$).

14. Dispositif selon la revendication 12 ou 13, **caractérisé en ce que** la bobine (S) est connectée à une capacité (C), de préférence variable, dans un circuit résonnant.

15. Dispositif selon l'une des revendications 12 à 14, **caractérisé en ce que** les valeurs du point d'entrée (-Vref) et du point de sortie (+Vref) de la fenêtre du comparateur à fenêtre (15, 16) sont fixées de manière symétrique à une ligne médiane, en particulier une ligne nulle, du signal du courant de bobine.

16. Dispositif selon l'une des revendications 12 à 15, **caractérisé par** un comparateur (14) pour constater le passage à zéro (NL) de la tension d'excitation ($u_e(t)$).

**17.** Dispositif selon l'une des revendications 12 à 16, **caractérisé en ce que** les moyens de détection de temps sont réalisés sous forme de compteurs numériques (18, 19) avec une fréquence de comptage constante.

**18.** Dispositif selon la revendication 17, **caractérisé en ce que** le signal de sortie (K1) du comparateur de passage à zéro (14) démarre les compteurs (18, 19) et, lors de l'entrée du courant de bobine ($i_M(t)$) dans la fenêtre du comparateur, le comparateur à fenêtre (15, 16) arrête un compteur (19), et lors de la sortie du courant de bobine ($i_M(t)$) hors de la fenêtre de comparateur, il arrête un autre compteur (18).

**19.** Dispositif selon la revendication 18, **caractérisé en ce que** l'on dérive, à partir de la différence des deux états des compteurs, la durée ($\Delta t_M$) dont le courant de bobine ($i_M(t)$) a besoin pour la traversée de la fenêtre de comparateur ($\Delta i$).

**20.** Dispositif selon la revendication 17, **caractérisé en ce que** le comparateur à fenêtre (15, 16) démarre un compteur lors de l'entrée du courant de bobine ($i_M(t)$) dans la fenêtre de comparateur et arrête le compteur lors de la sortie du courant de bobine ($i_M(t)$) hors de la fenêtre de comparateur.

**21.** Dispositif selon l'une des revendications 12 à 20, **caractérisé en ce que** les moyens de calcul (17) sont réalisés, pour la détermination du matériau de l'objet (O), de manière à comparer au moins une valeur maximum ($i_M$), déterminée pendant une phase de mesure discrète ($\phi_M$) avec des valeurs maximum correspondantes d'échantillons de référence.

**22.** Dispositif selon la revendication 18, **caractérisé en ce que** les moyens de calcul (17) sont réalisés pour utiliser la valeur de comptage du second compteur (19) à titre d'index d'un tableau de valeurs de référence et pour lire pour chaque valeur d'index (Ref_1 - Ref_5) une valeur seuil de référence (Lim_1 - Lim_5) associée à cet index, et la comparer avec la valeur de comptage du premier compteur (18), et conclure quant au matériau de l'objet (U) en cas de dépassement ou de passage au-dessous de la valeur seuil de référence respectivement utilisée (Lim_1 - Lim_5).

**23.** Dispositif selon l'une des revendications 12 à 22, **caractérisé en ce que** la tension d'excitation ($u_e(t)$) est réglée à une valeur entre 1 kHz et 1 MHz, de préférence entre 5 et 100 kHz, et de la façon la plus préférée entre 10 et 50 kHz.

**24.** Dispositif selon l'une des revendications 12 à 23, **caractérisé en ce qu'**un cycle de mesure est exécuté dans chaque période de la tension d'excitation ($u_e(t)$).

**25.** Installation de tri comprenant un système de convoyage (3) sur lequel un flux de matériau (2) est déplaçable avec une vitesse connue v, flux dans lequel sont contenus des objets (O) qui, en raison de leur conductibilité et/ou de leurs propriétés ferromagnétiques, sont reconnus et doivent être triés au moyen d'une unité de sortie d'objets (4), **caractérisée par** au moins un dispositif (10) pour différencier les objets (O) selon l'une des revendications 12 à 24, dans lequel la bobine (S) est agencée à proximité du système de convoyage (3) de sorte que des objets (O) qui se déplacent en direction de convoyage (direction x) du flux de matériaux (2) provoque une modification d'impédance, caractéristique du matériau, de la bobine (S), laquelle est détectée par le dispositif (10), et le dispositif (10) pilote l'unité de sortie d'objets (4).

EP 2 121 203 B1

Fig. 1

Fig. 2

16

# Fig. 3

# Fig. 6

Fig. 5

Fig. 4

EP 2 121 203 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1347311 A2
- DE 19838249 A1
- DE 10003562 A1
- AT 501669

**In der Beschreibung aufgeführte Nicht-Patentliteratur**

- **Tietze, U. ; Schenk, Ch.** Halbleiter-Schaltungstechnik. vol. 1058, 1212-1218